(19) Europäisches Patentamt
European Patent Office
Office européen des brevets

(11) **EP 4 567 667 A1**

(12) **EUROPEAN PATENT APPLICATION**

(43) Date of publication:
**11.06.2025 Bulletin 2025/24**

(21) Application number: **23214445.1**

(22) Date of filing: **05.12.2023**

(51) International Patent Classification (IPC):
**G06N 3/042** (2023.01)   **G06N 3/045** (2023.01)
**G06N 3/084** (2023.01)   **G06N 5/045** (2023.01)
**G05B 17/00** (2006.01)   **B60W 40/00** (2006.01)
**G05B 17/02** (2006.01)

(52) Cooperative Patent Classification (CPC):
**G06N 3/042; G05B 17/02; G06F 30/27;**
**G06N 3/045; G06N 3/084; G06N 5/045;**
**H04L 41/147; H04L 41/16;** H04L 41/145;
H04L 41/40

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **British Telecommunications public**
**limited company**
**London E1 8EE (GB)**

(72) Inventors:
• **PENA RIOS, Anasol**
**London E1 8EE (GB)**

• **CONWAY, Anthony**
**London E1 8EE (GB)**
• **ZIA, Muthammad**
**London E1 8EE (GB)**
• **ANJUM, Ashiq**
**London E1 8EE (GB)**

(74) Representative: **British Telecommunications**
**public limited company**
**Intellectual Property Department**
**9th Floor**
**One Braham**
**Braham Street**
**London E1 8EE (GB)**

(54) **DIGITAL TWIN WITH PHYSICS AND LEARNING BLOCKS**

(57)    A digital twin is described for controlling entities such as software defined communications networks. Sensor data is observed from an entity and input to a digital twin of the entity, the digital twin comprising at least one learning block, and at least one physics block encoding a rule. The sensor data is processed through the learning block and the physics block such that the data follows a path through the digital twin through the blocks and along one or more connections between the blocks to generate an output. Automated control of the entity may be triggered in dependence on the generated output.

FIG. 1

## Description

The present disclosure relates to digital twin technology, including but not limited to digital twin technology used in communications network control.

BACKGROUND

A digital twin is a computer-implemented model of an entity that may be used to facilitate a range of tasks including but not limited to testing of the entity, maintenance of the entity, upgrade of the entity, design of the entity, control of the entity. The quality of performance of a digital twin for any of these tasks depends on the accuracy of the computer-implemented model; that is, how well the computer-implemented model represents the behaviour of the entity. Achieving good quality of performance in an efficient manner is not straightforward and is often difficult to achieve where there is limited sensor data available describing the behaviour of the entity.

The examples described herein are not limited to examples which solve problems mentioned in this background section.

SUMMARY

Examples of preferred aspects and embodiments of the invention are as set out in the accompanying independent and dependent claims.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

According to a first aspect there is a computer implemented method comprising:

receiving sensor data observed from an entity;
inputting the sensor data to a digital twin of the entity, the digital twin comprising at least one learning block, and at least one physics block encoding a rule;
processing the sensor data through the learning block and the physics block such that the data follows a path through the digital twin through the blocks and along one or more connections between the blocks to generate an output;
triggering control of the entity in dependence on the generated output.

The method gives an efficient way to control the entity in an automated manner. Because the control is automated there is less room for human error. By using a learning block as well as a physics block that encodes a rule it is possible to obtain a high quality digital twin even where there is limited sensor data available. Because the data follows a path through the blocks and along connections between the blocks, the output of the digital twin takes into account both the learning block and the physics block. The digital twin is found to be particularly suited for use with entities where one or more rules are known describing at least part of the behaviour of the entity. It is found that communications protocols in packet based communications networks are well suited to this type of digital twin since the protocols comprise rules describing behaviour and yet there are often other behaviours in the communications network which are difficult to describe with rules and are better suited to modelling using machine learning. The present technology provides a modular way to combine both machine learning (in learning blocks) and physics rules (such as mathematical operators, if then rules, laws of nature, rules of physics) which results in high performing digital twins.

In some examples the digital twin has been trained using supervised learning, by backpropagation along the whole of the path, and wherein the backpropagation comprises computing gradients of a loss that is constrained by the physics block. Using supervised learning enables the learning block(s) to be trained so they are likely to have high accuracy since supervised learning is known to generally produce models which are more accurate that those trained using unsupervised learning. Using backpropagation comprising computing gradients of a loss that is constrained by the physics block enables the learning block(s) to be trained such that they comply with the rule encoded in the physics block. Because the backpropagation is along the whole of the path there is end-to-end training of the digital twin.

In some examples the method comprises generating an explanation of the output, the explanation comprising values of the sensor data processed through the physics block, information about the rule encoded by the physics block, and optionally an output of the data block. Being able to generate an explanation, even where the explanation is a partial explanation, is particularly useful. The explanation enables a human user, such as a telecoms network operator, to gain understanding of why the digital twin computed a particular output in a given situation. Having an explanation is useful to facilitate human oversight of control of the entity.

In some examples the path comprises at least one residual block trained to predict a residual. In various examples there is one residual block per learning block. Using residual block(s) facilitates stability during the back-

propagation.

In some examples the physics block is represented using a differentiable function. Having a differentiable function facilitates use of backpropagation as efficiency of computing gradients of the loss is gained.

In some examples the learning block and the physics bock are connected either in series or in parallel. Using blocks gives benefits of modularity since blocks are connectable in various different ways and can be re-used.

In examples the entity is any of: a self-driving vehicle, a communications network, a software-defined network. Thus the entity may be a physical entity or an entity such as a virtual network function, a virtual machine.

In examples the entity is a communications network and the physics block encodes any of: a rule about behaviour of a queue in a Border Gateway Protocol node of the communications network, a rule about behaviour of a node in the communications network using transport control protocol, a rule about traffic engineering in a software defined network. These are example of rules that the physics block may encode and are not an exhaustive list of examples.

In examples the entity is a communications network and the learning block predicts any of: latency of packet transmission, throughput of packets, packet loss, buffering delay, backbone congestion. Using a learning block to predict these types of quantities, which are time consuming and difficult to measure directly, is particularly useful.

In examples the method comprises any of: adding a block to the path, removing a block from the path. Adding and removing blocks is useful as it enables the digital twin to be modified in a straightforward manner, for reuse with different entities or for adjusting the ratio between physics blocks and learning blocks in the digital twin according to particular applications.

In examples the method comprises training the digital twin using supervised learning, by backpropagation along the whole of the path, and wherein the backpropagation comprises computing gradients of a loss that is constrained by the physics block. Since the gradients are constrained by the physics block it is possible to ensure the learning block(s) are trained in a way to comply with the physics block rule.

In examples the method comprises inputting the sensor data to a simulator to compute simulated values of the output and using the simulated values to compute the loss. Using a simulator enables simulated values to be obtained that can be used as "ground truth" values during the supervised learning. However, it is not essential to use a simulator if the ground truth values are obtainable in other ways such as from human experts or empirical observation.

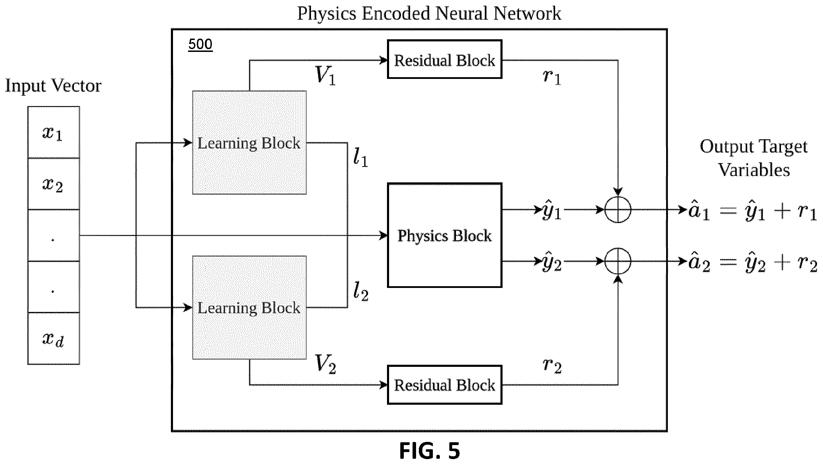

In examples the entity is a self-driving vehicle and the learning block predicts a lookahead distance and wherein the physics block comprises mathematical operators. The digital twin is found to be particularly effective where the learning block predicts a lookahead distance and the physics block comprises mathematical operators as explained in more detail below with reference to FIG. 5.

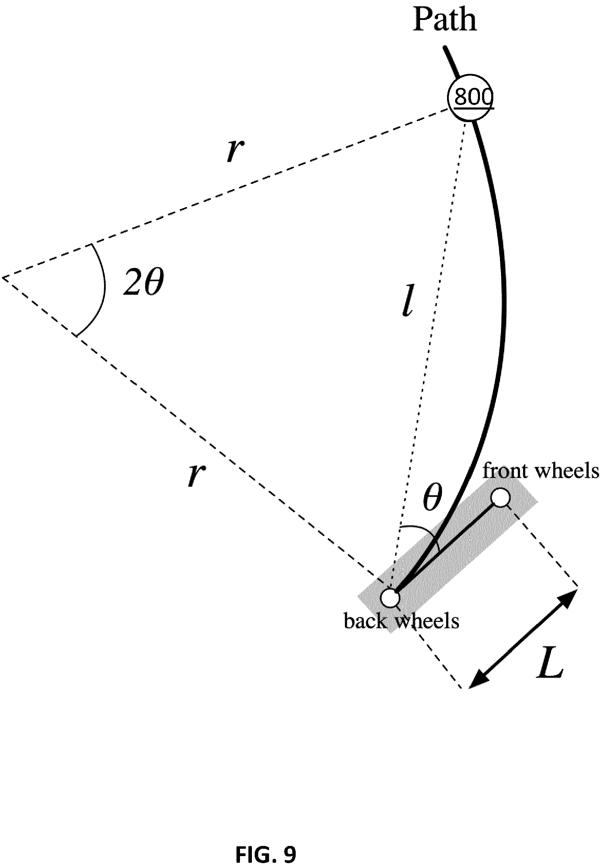

In examples the entity is a border gateway control protocol communications network and wherein the digital twin comprises a plurality of learning blocks and a plurality of physics blocks. This type of arrangement is explained in one example with reference to FIG. 9 and is found very effective as communications protocols are well suited to being described using rules.

In a second aspect there is a computer implemented method comprising:

> receiving sensor data observed from an entity;
> inputting the sensor data to a digital twin of the entity, the digital twin comprising at least one learning block, and at least one physics block encoding a rule;
> processing the sensor data through the learning block and the physics block such that the data follows a path through the digital twin along one or more connections between the blocks and generates an output;
> training the digital twin by computing a loss from the generated output and propagating the loss along the path, the loss being constrained by the physics block.

This method gives an efficient way to train a digital twin even where there is limited sensor data available. The method is found to result in a digital twin with good generalization ability.

In a third aspect there is an apparatus comprising:

> a memory storing sensor data observed from an entity;
> a digital twin of the entity, the digital twin comprising at least one learning block, and at least one physics block encoding a rule;
> a processor to process the sensor data through the learning block and the physics block such that the sensor data follows a path through the digital twin along one or more connections between the blocks and generates an output;
> the processor triggering control of the entity in dependence on the generated output.

It will also be apparent to anyone of ordinary skill in the art, that some of the preferred features indicated above as preferable in the context of one of the aspects of the disclosed technology indicated may replace one or more preferred features of other ones of the preferred aspects of the disclosed technology. Such apparent combinations are not explicitly listed above under each such possible additional aspect for the sake of conciseness.

Other examples will become apparent from the following detailed description, which, when taken in conjunction with the drawings, illustrate by way of example the principles of the disclosed technology.

BRIEF DESCRIPTION OF THE DRAWINGS

FIG. 1 is a schematic diagram of a digital twin deployed in a control system controlling a communications network;
FIG. 2 is a schematic diagram of a digital twin deployed in a control system controlling a self-driving vehicle;
FIG. 3 is a flow diagram of a method of training a digital twin such as that of any of FIGs. 1 and 2;
FIG. 4 is a flow diagram of a method of operation of a digital twin in a control system such as that of any of FIGs. 1 and 2;
FIG. 5 is a schematic diagram of a digital twin showing residual blocks;
FIG. 6 is a schematic diagram of a digital twin for controlling a self-driving vehicle steering angle;
FIGs.7 shows look ahead distance variation;
FIG. 8 shows geometry of an environment of a self-driving vehicle;
FIG. 9 shows geometry of a path a self-driving vehicle is travelling on;
FIG. 10 is a schematic diagram of a digital twin for controlling a Border Gateway Control Protocol communications network;
FIG. 11 is a schematic diagram of a computer for implementing a digital twin.

The accompanying drawings illustrate various examples. The skilled person will appreciate that the illustrated element boundaries (e.g., boxes, groups of boxes, or other shapes) in the drawings represent one example of the boundaries. It may be that in some examples, one element may be designed as multiple elements or that multiple elements may be designed as one element. Common reference numerals are used throughout the figures, where appropriate, to indicate similar features.

DETAILED DESCRIPTION

The following description is made for the purpose of illustrating the general principles of the present technology and is not meant to limit the inventive concepts claimed herein. As will be apparent to anyone of ordinary skill in the art, one or more or all of the particular features described herein in the context of one embodiment are also present in some other embodiment(s) and/or can be used in combination with other described features in various possible combinations and permutations in some other embodiment(s).

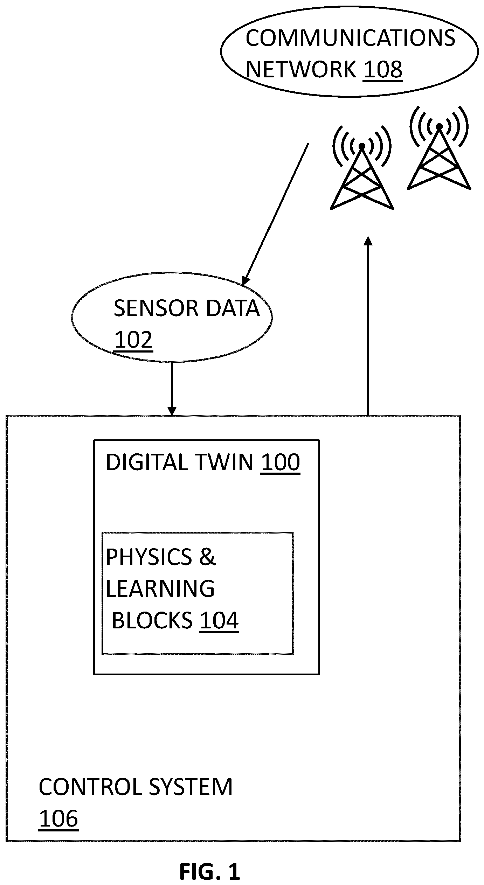

Figure 1 of the accompanying drawings shows a digital twin 100 comprising physics and learning blocks 104. The digital twin 100 comprises at least one learning block which is suitable for training using supervised machine learning. In an example, a learning block comprises any of: a convolutional neural network, a multi-layer perceptron, a recurrent neural network, or any other type of neural network. The term "learning block" refers to computer implemented functionality which is trainable using supervised machine learning. The digital twin 100 comprises a least one physics block. A physics block is computer implemented functionality encoding at least one rule such as an if then rule, a mathematical operator, a law of physics, a law of nature, a communications network protocol, a communications network policy. Within the digital twin the physics block and learning block are connected together. There can be more than one physics block and/or more than one learning block. The blocks are modular; that is they can be connected together in different topologies, can be re-used between different digital twins, can be removed or replaced. The blocks are connected together to form a path along which computation flows through the digital twin. The path can have forks, branches or loops.

In the example of FIG. 1 the digital twin model's behaviour of a communications network 108 such as a mobile communications network, software defined communications network, or other communications network. The digital twin is configured to model the communications network 108 by defining the physics blocks according to known aspects of how the communications network operates. These known aspects are obtained either from empirical observations or by using knowledge about the communications network, such as its topology, design or orchestration. The physics blocks may be defined by a human engineer or may be selected from a library of available physics blocks, where the selection is made automatically using information about the communications network infrastructure and topology. In some examples, the physics blocks within the digital twin may be represented by a differentiable function.

The digital twin is also configured to model the communications network 108 by selecting one or more learning blocks and determining how to connect the learning block(s) and physics block(s) together to form the path. The selection is done either manually or by automatic selection from a library of available learning blocks according to selection criteria. The determination of how to connect the blocks to form the path is done either manually or using automation, such as by trial and error or using knowledge of how the communications network works.

In the example of FIG. 1 the digital twin 100 is deployed in a control system 106 which is in the cloud or at a management node of the communications network 108. The control system 106 receives sensor data 102 from the communications network 108. The sensor data is any of: packet loss rate, bandwidth availability, jitter, round trip time or other metrics measured in the communications network. The digital twin 100 computes predictions of behaviour of the communications network 108 and the prediction is used by the control system 106 to trigger control of the communications network 108. In various examples the control system 106 sends instructions to carry out actions such as: isolate a node of the communications network, replicate a node of the communications network, upgrade a node of the communications network. In some cases the instructions update a configuration file of a virtual network function and the configuration file is sent to an orchestrator which instructs instantiation of containers deploying the virtual network function in a distributed fashion through the communications network 108. In some cases the instructions update a software defined communications network by updating entries in tables defining traffic flows.

In some examples the control system 106 has a graphical user interface that displays output from the digital twin 100 together with an explanation or partial explanation of the digital twin output. The explanation is formed by stating the rules encoded by any physics blocks of the digital twin and stating values predicted by any learning blocks of the digital twin. The explanation may update over time and the graphical user interface may display the explanation over time to indicate historical trends.

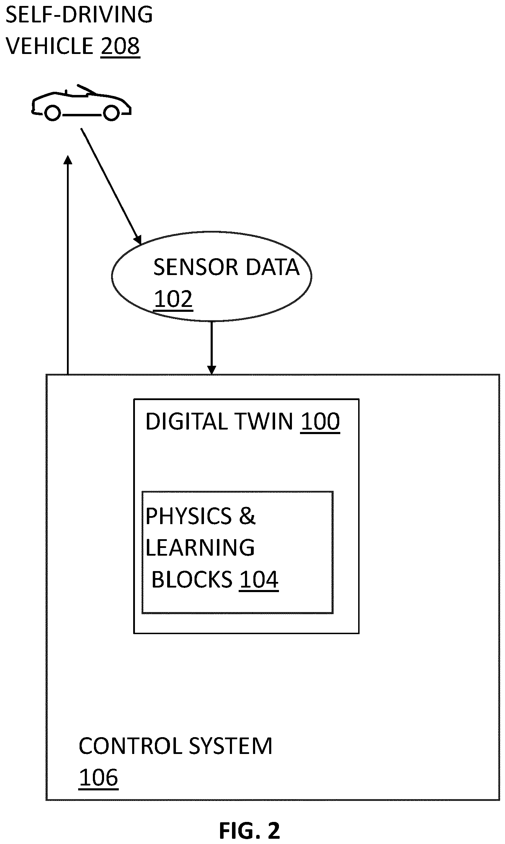

FIG. 2 is a schematic diagram of a digital twin 100 similar to that of FIG. 1 and used in a control system 106 for controlling a self-driving vehicle 208. The control system 106 is deployed in the self-driving vehicle 208. The digital twin 100 comprises at least one physics block and at least one learning block as for FIG. 1. The particular arrangement of how the blocks are connected and what training data is used to train the digital twin are different from the digital twin of FIG. 1.

The digital twin 100 of the present technology combines data-driven and physics-based approaches to address the limitations of generating models of real-world entities for digital twins. Data-driven modelling techniques such as supervised learning require a significantly large amount of observation data to produce accurate models and offer a largely black-box model. Physics-based simulations on the other hand offer reliable and accurate models but suffer from generalizability to new scenarios. The digital twin has a hybrid architecture that combines machine learning and physics to model the complex behaviour of real-world systems. This hybrid architecture captures both known physical relationships and unknown variables from the environment within a single, differentiable digital twin that is capable of learning from observation data.

The digital twin has improved generalizability: the hybrid model generalizes well to new scenarios, addressing a limitation of both purely data-driven and physics-based approaches.

The digital twin has lower data requirements: the model requires significantly less observational data for training compared to traditional imitation learning methods, making it scalable and practical.

The digital twin has an interpretable mechanism: by integrating known physics into the digital twin, it offers a level of interpretability often lacking in purely data-driven models.

The digital twin has modularity: the architecture is modular, allowing for the integration of different types of physics models, thereby making it adaptable to a range of real-world systems.

The digital twin is usable to control the entity it represents such as by running 'whatif scenarios using the digital twin, using the digital twin for predictive maintenance, and system optimization.

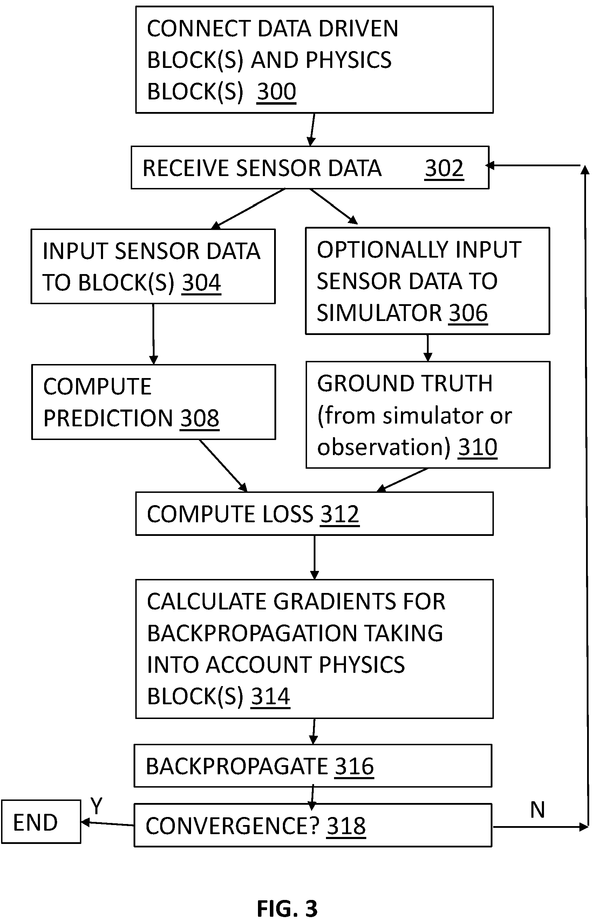

FIG. 3 is a flow diagram of a method of training a digital twin such as that of any of FIGs. 1 and 2. The method of FIG. 3 is performed by training functionality such as compute nodes in the cloud or at the control system such as the control system of FIGs. 1 and 2. The digital twin is formed by connecting 300 at least one learning block and at least one physics block together as described above with reference to FIG. 1. Sensor data is received 302 at the digital twin. The sensor data is received over a wired or wireless connection from sensors in the entity the digital twin represents or from sensors in an environment of the entity.

The sensor data is input 304 to the digital twin such as by inputting the sensor data at one end of a path formed by the connected blocks. Computations are carried out on the sensor data in first blocks of the path and the results of the computations are passed to the next blocks of the path and so on, until an output is produced i.e. a prediction is computed 308.

The sensor data is optionally input 306 to a simulator which computes simulated values of the output of the digital twin. The simulator simulates the entity. The simulator is independent of the digital twin. In an example, the simulator is a communications network simulator such as any commercially available network simulator including but not limited to: ns simulator, OPNET, NetSim, GloMoSim. Where the entity is a self-driving vehicle the simulator is a self-driving vehicle simulator such as TORCS open-source driving simulator. The output of the simulator is a "ground truth" 310 value which is assumed to be a correct value of the decision or quantity the digital twin is seeking to predict about the entity's behaviour. It is not essential to use a simulator. In some cases the ground truth values are obtained through empirical observation.

The training functionality computes 312 a loss using the computed prediction 308 and the ground truth value. The loss is any metric expressing a difference between the computed prediction and the ground truth value such as a mean squared difference or other loss.

The training functionality calculates 314 gradients for backpropagation taking into account the physics blocks 314. Backpropagation 316 is carried out along the path from the output to the input(s) where the path includes the physics blocks and the learning blocks. The backpropagation makes no changes to the physics blocks and updates parameters of the machine learning elements in the learning block(s). However, the backpropagation process does pass through the physics blocks in the sense that the backpropagation process takes into account or is constrained by the physics blocks; to ensure that the learning block(s) comply with the rules of the physics blocks. In some examples the digital twin comprises one or more residual blocks which have been trained to predict residuals as explained in more detail below.

The training functionality checks whether convergence has been reached by checking whether changes to the parameters of the learning blocks were de minimis or checking whether a specified number of training iterations has taken place. In response to convergence being reaches the process ends and the digital twin is stored. In response to convergence not being met, the process of FIG. 3 repeats from operation 302.

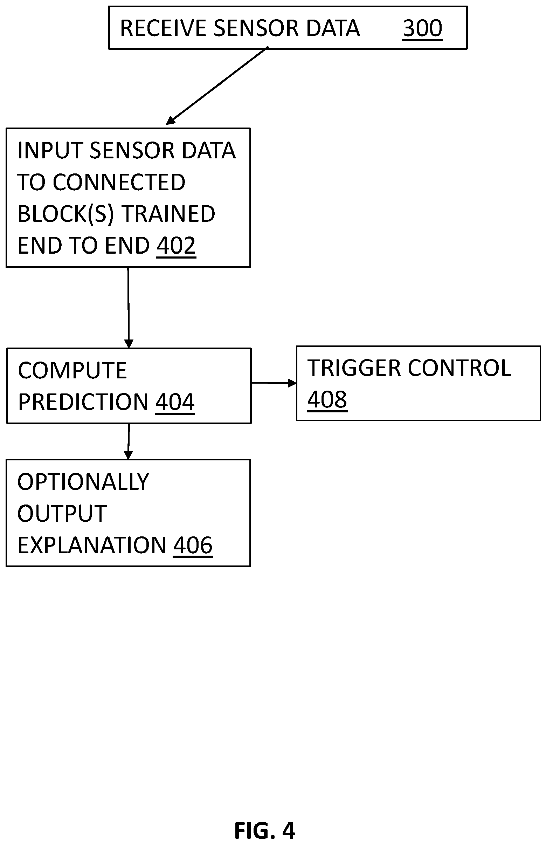

FIG. 4 is a flow diagram of a method of operation of a digital twin in a control system such as that of any of FIGs. 1 and 2. Sensor data is received 300 over a wired or wireless connection from sensors in the entity or an environment of the entity. In some cases the sensor data comprises data derived from sensor data such as mean sensor data values. The sensor data is input 402 to the digital twin which comprises connected blocks that have been trained end-to-end. That is the digital twin comprises at least one learning block and at least one physics block connected to form a path and where training has been done end-to-end along the whole path.

The digital twin computes 404 a prediction. This is done by inputting the sensor data as explained in operation 402 and the sensor data is processed one or more first blocks of the path to produce intermediate results. The intermediate results are passed forwards along the path into one or more next bocks of the path. Those next blocks process the results and pass their own results forwards along the path into other bocks. This forwarding and processing carries on until an output of the path is reached where the output is a result which is the computed prediction. The computed prediction triggers 408 a control action such as sending instructions to the entity to control the entity. The digital twin optionally outputs 406 an explanation giving information such as values of predictions computed by any learning blocks on the path, information about rules of any physics blocks of the path, information about the topology of the path.

In a non-limiting example where the learning block is a neural network the training process is expressed mathematically as follows.

Physics blocks are implemented as custom layers within a modular neural network architecture to model the complex behaviour of real-world systems. The goal is to capture unknown variables in the environment in combination with known physical relationships inside a single, differentiable model that is capable of learning from observation data generated by the target system. The known physical knowledge of the target system is represented as a differentiable physics model. Expert demonstrations from the target system are directly used to learn a policy to model observed states to actions taken.

For a set of expert demonstrations T from the target system, assume i..i..d. stateaction pairs as:

$$T = \{(s_2, a_2), (s_2, a_2) \ldots (s_n, a_n)\}$$

Define a learning block as a set of fully connected layers $\mathcal{L}(x; \theta)$ that takes observed state vector x and outputs an intermediate state vector $l$. The learning block has a set of trainable weights $\phi$.

$$l = \mathcal{L}(x; \phi)$$

This intermediate state could include unknown variables from the environment or parts of the behaviour that are not directly defined by prior physics and thereby require empirical modelling. Also define a physics block as a computational graph $\mathcal{P}$ that predicts an action

$$a \in \mathcal{A},$$

from the available set of actions $\mathcal{A}$ usually taken by the target system, using the observed state x and the intermediate state $l$

$$\hat{a} = \mathcal{P}(x, l)$$

While the physics blocks provide key a priori knowledge to the model, they pose a significant problem in converging the loss function in the gradient descent algorithm. If the fixed relationships dictated by these layers conflict with the patterns the learnable parts of the network are trying to model, it can result in conflicting gradients. This conflict can make the training process highly unstable, leading to difficulties in achieving convergence. Furthermore, static layers, such as those representing fixed physics equations, do not have adjustable weights (learnable parameters). When these static layers are integrated into a neural network, they can disrupt the flow of gradients to the learnable layers, often exacerbating the known problems of vanishing and exploding gradients.

To overcome this problem, add 'residual blocks' that branch out from the learning blocks to predict residual target value to be added to the physics block output. This introduces alternative pathways for gradients to flow to the learning blocks, mitigating the effect of the static layers within the physics blocks.

FIG. 5 shows an example case with two target intermediate variables and two target values to be predicted by the model. Intermediate, unknown variables $l_1$ and $l_2$ are predicted (discovered) by the learning blocks and passed to the physics block as inputs alongside the original input vector X. Intermediate feature vectors $V_1$ and $V_2$ are passed from the learning blocks to the residual blocks to predict residual target values $r_1$ and $r_2$. The residuals eventually add up with the physics-predicted target values $y_1$ and $y_2$ to output the final target values $a_1$ and $a_2$.

An intermediate layer output vector $V$ from the learning block $\mathcal{L}$ is passed to a separate residual block $\mathcal{R}$, which also comprises trainable parameters $\phi_r$.

$$r = \mathcal{R}(V; \phi_r)$$

The residual target value r is then be added to the output from the physics blocks to predict the action $\hat{a}$.

$$\hat{a} = \mathcal{P}(\mathbf{x}, \mathbf{l}) + r$$

Thereby, the final policy function is:

$$\hat{a} = \pi(\mathbf{x}, \mathcal{L}, \mathcal{P}, \mathcal{R}) \text{ where } \hat{a} \in \mathcal{A}$$

The gradient descent algorithm optimises any suitable loss function $L(a, \hat{a})$ that defines the difference between $a$ and $\hat{a}$. Since the policy function is differentiable and comprises the affine connection of $\mathcal{L}$ and $\mathcal{P}$, the gradients from $\nabla L$ will flow through the chain of static operators from the physics block $\mathcal{P}$ to optimize the weights in the learning block $\mathcal{L}$, thereby modulating the learning of intermediate unknown variables using known physical constraints of the system. This essentially gives the final model the capacity to learn unknown, empirical relationships in data while maintaining the fundamental structure of the physics of the behaviour being modelled.

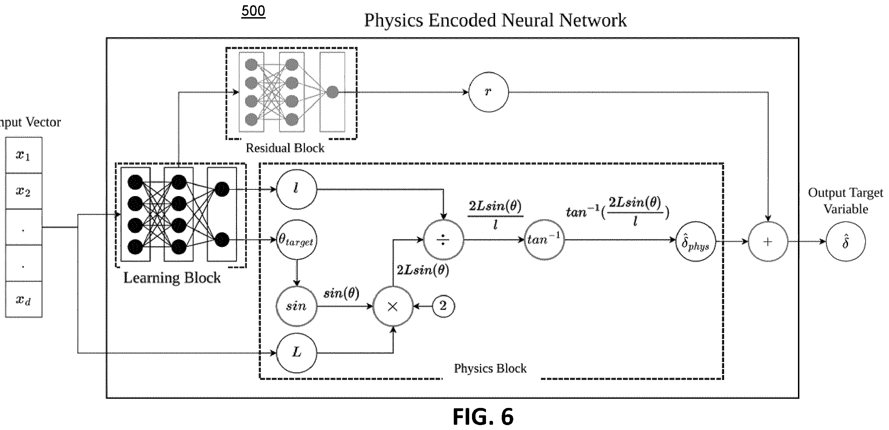

FIG. 6 is a schematic diagram of a digital twin for controlling a self-driving vehicle steering angle. In this example the digital twin comprises one learning block which is a fully connected, feedforward neural network that predicts a lookahead distance denoted l and also predicts a heading difference $\theta_{target}$. The digital twin comprises only one physics block which comprises a plurality of mathematical operators denoted x, sin, /, tan$^{-1}$. The physics block also comprises a scaling factor (2 in this example) and a length of the self-driving vehicle denoted L. The heading difference is an angle (denoted $\theta_{target}$) between the self-driving vehicle direction and a direction of a track axis, where the track is a track on which the self-driving vehicle is driving and the track axis is a longitudinal axis of the track. The physics block and the learning block are connected together as illustrated. A vector of sensor data values (denoted X in FIG. 6) is input to the digital twin and flows into both the learning block and the physics block. The learning block and the physics block are connected together via mathematical operator / as indicated. A residual block branches off from the learning block. The residual block comprises a neural network that predicts a residual r. The predicted residual r is added to the output of the physics block as illustrated. The output of the digital twin is a predicted target steering angle. The predicted target steering angle is used to control the steering angle of the self-driving vehicle in an automated manner.

The digital twin of FIG. 6 may be used in an autonomous driving task of steering a vehicle in a simulation as it manoeuvres around an empty racetrack i.e., in the absence of other vehicles. Using data generated from an existing driving agent within the simulation (treated as an expert driving system), train a feed-forward neural network architecture that combines fully connected layers that capture perceptual understanding with relevant mathematical operators from the physics-based steering model known as Pure Pursuit.

In the example of FIG. 6 the TORCS open-source driving simulator was used to train the digital twin. The TORCS simulator has good diversity of tracks and rich non-visual sensory and perceptual information. The input parameter space offered to the digital twin comprised of a set of vehicle's state variables and perception information from the surrounding environment. The following table summarizes the variables from the simulation environment that were used as input parameters and actuators/actions for the digital twin.

| Variable | Range (unit) | description |
|---|---|---|
| $\alpha$ | [-π, +π] (rad) | Angle between the car direction and the direction of the track axis |
| D | (-∞, +∞) (m) | Distance between the car and the track axis. The value is normalized with respect to the track width: it is 0 when the car is on the axis, -1 when the car is on the right edge of the track and +1 when it is on the left edge of the car |
| z | (-∞, +∞) (m) | Distance of the car mass centre from the surface of the track along the z axis |
| V | (-∞, +∞) (km/h) | Speed of the car as a vector in $R^3$ |
| R | [0-200] (m) | Vector of 19 range finder sensors as explained below |
| W | [-1, +1] | Steering value: -1 and +1 means respectively full right and left, which corresponds to an angle of 0.366519 rad |
| a | [0,1] | Virtual acceleration pedal (0 means no gas, 1 full gas) |
| b | [0,1] | Virtual braking pedal (0 means no brake, 1 full brake) |

The vector of 19 range finder sensors R, comprises the distance between the track edge to the car centre within a range of 200 meters. Each value represents distances spanning clockwise from -90 degree to +90 degrees with respect to the car axis. This is similar to how an automotive RADAR sensor is used to localize objects in the long-range vicinity of an autonomous vehicle.

To aid understanding of the embodiment of FIG. 6 the pure pursuit algorithm is now explained. It is a path-tracking algorithm that is used to steer a vehicle along a desired path. The algorithm works by calculating the steering angle required to follow the path based on the vehicle's current position and velocity. It operates based on the concept of "pursuit," where a hypothetical point, known as the look-ahead point, is established ahead of the vehicle on the desired path. The objective is to steer the vehicle towards this point, thereby ensuring path tracking. The algorithm computes the optimal steering angle required to reach the look-ahead point by analysing the geometric relationship between the vehicle and the path.

Firstly, the pure pursuit algorithm estimates the position of the look-ahead point by projecting it along the desired path based on the vehicle's current position. In contrast the digital twin predicts the look ahead distance and heading difference using the learning block. Using geometry the look ahead point (also referred to as a selected point) is found from the heading difference and the look ahead distance. Subsequently, the algorithm computes the curvature of the path at the look-ahead point using mathematical techniques such as interpolation or curve fitting. Finally, utilizing the vehicle's kinematic model, the algorithm calculates the required steering angle to navigate towards the look-ahead point. The look-ahead distance, which is the distance from the vehicle to the look-ahead point, is a control parameter in the context of the algorithm and affects the outcome in two contexts:

- Regaining a path, i.e., the vehicle is at a "large" distance from the path and must attain the path.
- Maintaining the path, i.e., the vehicle is on the path and wants to remain on the path.

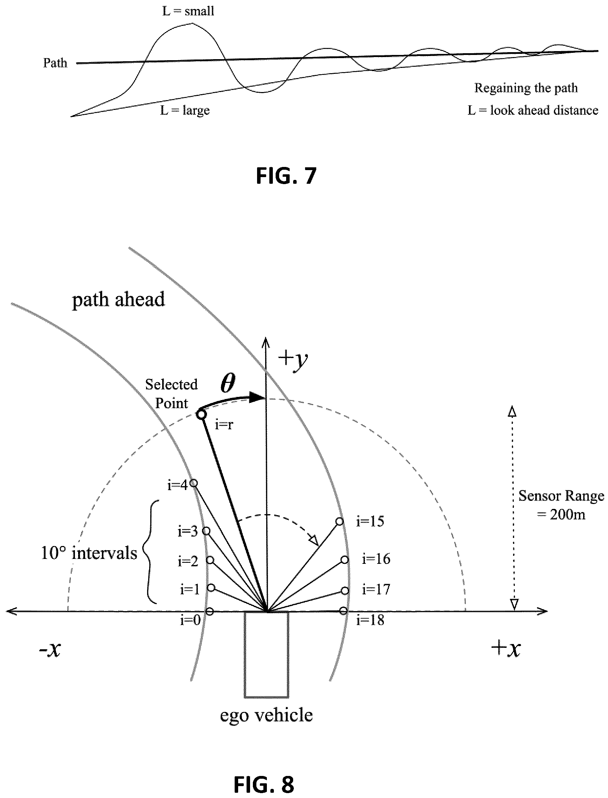

FIGs.7 shows look ahead distance variation. Longer look-ahead distances tend to converge to the path more gradually and with less oscillation, as illustrated in FIG. 7. It, therefore, depends on the state of the driving environment at any point in time to optimally set the look-ahead distance to safely manoeuvre the track.

In the case of a partially observable driving environment, waypoints on a reference path are not available to the algorithm to select a look-ahead point. Thus the digital twin predicts the look ahead distance and heading difference using a learning block in order to obtain the look ahead point. In an example the digital twin selects the look-ahead point to be in the direction of the furthest point on the road boundary from the vehicle, using the range finding sensor vector R as now explained with reference to FIG. 8.

FIG. 8 shows geometry of an environment of a self-driving vehicle. FIG 8 is a schematic "bird's eye view" of a self driving vehicle (shown as a rectangle) which seeks to travel along a curved path. FIG. 8 illustrates a heuristic which is used to compute the heading difference for use as training data in a first phase of training the digital twin (as explained later in this document). The heuristic is not essential. The edges of the path are indicated by curved lines in FIG. 8 either side of the words "path ahead". The vehicle is currently on the path. Range finder sensors on the vehicle can be considered to run clockwise from the vehicle's horizontal plane i.e., from the left side of the vehicle, forming a semi-circle axis in front of the vehicle. The sensors capture values every 10 degrees on this axis, clipped to a maximum value of 200m. The values captured by the range finder sensors indicate the presence of a road boundary at the corresponding angle value. Mathematically, for $R^t$ as the vector of range finder sensors at any time instance t, define:

$$i = argmax(R^t)$$

$$\theta^t = 10i - \frac{\pi}{2}$$

Here, $\theta^t$ is the angle between the vehicle's heading and the selected look ahead point on the road, which is referred to as heading difference. Assume that the vehicle follows the principle of a rigid body moving around a circle, and therefore compute the required steering angle using the instantaneous centre of rotation of this circle as explained and illustrated in FIG. 9.

FIG. 9 shows geometry of a path a self-driving vehicle is travelling on. FIG. 8 is a bird's eye view of a vehicle represented as a rectangle, travelling on a curved path. From the arc of rotation depicted in the FIG. 9, use the law of sine to calculate the curvature, *k*, of the path to the selected look-ahead point 800 as equation 1:

$$k = \frac{1}{r} = \frac{2sin(\theta)}{l} \; equation \; 1$$

Here, r is the radius of rotation for the vehicle. Furthermore, using the kinematic bicycle model the radius of rotation has an inverse relationship with the steering vehicle as:

$$r = L/tan(\delta)$$

Here, $\delta$ is the steering angle and L is the length of the vehicle. Therefore, substitute r from the equation of curvature (Equation 1) to get the required steering angle as equation 2:

$$\delta = arctan\left(\frac{2Lsin(\theta)}{l}\right) \; equation \; 2$$

Thus the physics block in the digital twin of FIG. 6 comprises mathematical operators to compute the steering angle using the above equation (equation 2) and the prediction of the look ahead distance from the learning block.

In the example of FIG. 6, the mathematical operations behind calculating the target steering angle within the Pure Pursuit algorithm are integrated with the fully connected layers of a feed-forward neural network. The look-ahead distance and the heading difference are key parameters that dictate the behaviour of the vehicle. The learning block, comprising a set of fully connected layers is used to output a predicted optimal look-ahead distance and heading difference representing the selected reference point on the road based on the input sensor data depicting the current road geometry and the car's sensory measurements. This is then fed to a set of static tensors expressing the steering angle as a geometric combination of the lookahead distance from the fully connected layers and the heading difference (using equation 2).

The term "static tensors" is used to refer to mathematical operators or rules that do not involve learnable weights. These include the operations in equation 2 to calculate the target steering based on the input variables.

To formally define each block, let x be the vector of input parameters (explained in the above table). Assume $\mathcal{L}(x, \phi)$ represents the function modelled by the learning block predicting the lookahead distance *l* and target heading difference $\theta_{target}$, with known input variables x and a set of learnable weights $\phi_{learn}$.

$$\mathcal{L}: R^d \times R^m \rightarrow R^2$$

$$\mathcal{L}(x, \phi) = \begin{bmatrix} l \\ \theta_{target} \end{bmatrix}$$

where d is the number of state features in the input vector (from available state parameters shown in Table 1) and m is the total number of weights in the fully connected layers.

Assume a physics block $\mathcal{P}(x, \mathcal{L})$ to predict the steering value $\delta_{phys}$ using the known input state and the intermediate unknown variables predicted by $\mathcal{L}$, using operators from Equation 2.

$$\mathcal{P}(x, \mathcal{L}) = arctan\left(\frac{2Lsin(\theta)}{\mathcal{L}(x)}\right)$$

Define a residual block $ReV; \phi_{res})$ comprising a set of fully connected layers with learnable weights $\phi_{res}$, which inputs a feature vector from an intermediate layer from the learning block $\mathcal{L}$ as input. The residual block predicts the residual target value r, which is added to the physics-predicted steering value $\delta_{phys}$ to formulate the final steering value from the model.

$$\hat{\delta} = \mathcal{P}(\mathbf{x}, \mathcal{L}) + r$$

Assume a set of demonstration data T from an expert driving agent as i.i.d state-action pairs:

$$T = \{(\mathbf{x}_1, \delta_1), (\mathbf{x}_2, \delta_2) ... (\mathbf{x}_n, \delta_n)\}$$

Here, $x_i$ and $\delta_i$ are observed input state and steering values from the expert driving agent. Define the predicted steering value (target value) based on the policy function $\pi$ as:

$$\hat{\delta} = \pi(\mathbf{x}, \mathcal{L}, \mathcal{P}) \text{ where } \hat{a} \in \mathcal{A}$$

The loss function is based on RMSE (Root Mean Squared Error), minimizing the error between the observed ($\delta$) and predicted ($\hat{\delta}$) steering angles. This is defined as:

$$\mathcal{L} = \frac{1}{n}\sum_{i=1}^{D}\left(\delta_i - \hat{\delta}\right)^2$$

Use the Mini-Batch Gradient Descent algorithm and Adam Optimizer to optimize the loss function, where $n$ is any arbitrary batch size for each sample in the gradient descent algorithm. The gradients for the learnable weights in $\phi_{learn}$ are calculated by the chain of function derivatives that involve the geometric and kinematic operators from Equation 2. This allows the feed-forward network to learn the optimal lookahead while being forced to comply with the geometric and kinematic aspects of the steering problem dictated by the pure pursuit algorithm. This is done by constraining the calculation of gradients, which are calculated as an explicit part of the equations based on the pure pursuit algorithm. On the other hand, the residual block provides an alternative pathway for the gradients to flow back to the intermediate layers of the learning block. This allows the loss function to converge and optimise the weights in the residual and, more importantly, the learning block.

The calculation of gradients for back-propagation in the gradient descent algorithm is novel where:

$$\frac{\partial g}{\partial f} = \nabla\phi f \cdot \frac{1}{1 + f(x)^2}$$

allows the feed-forward network to learn the optimal lookahead while being forced to comply with the geometric and kinematic aspects of the steering problem dictated by the pure pursuit algorithm. This is done by constraining the calculation of gradients which are calculated as an explicit part of the equations based on the pure pursuit algorithm. Since the approach essentially discovers the optimal value of the lookahead distance based on the state, while maintaining the physical constraints of the pure pursuit model, it may not necessarily imitate the exact behaviour of an expert all the time. The final trained model will be able to produce optimal driving behaviour and may, in certain instances, implicitly discover that the expert's actions do not follow the physics dynamics set by the pure pursuit model thereby maintaining a trade-off.

To train the digital twin, such as the digital twin of FIG. 6, it is possible but not essential to use a two phase process. The two phase process gives efficiency and is now explained.

In an example train the digital twin on the demonstration data T in two sequential phases. The first phase involves a warm-start phase where the learning block is trained separately to predict appropriate lookahead distance (I) and target heading difference (θ_target) values. Generate two batches of data from a driving simulation. The first batch is generated from the agent driving on empty segments of tracks, and the second batch is generated from the agent driving amongst other traffic vehicles.

Phase I: Warm Start

In this phase, the learning block is trained separately on the first dataset (D_1) collected from empty road scenarios. Define a heuristic function to provide the learning block with proposed values of lookahead distance (I) and target heading difference (θ_target) for each data point. The heuristic function selects the reference point to be in the direction of the furthest point on the road boundary from the vehicle, using the range-finding sensor vector R (refer to the above table). The heuristic is explained with reference to FIG. 8.

The range finder sensors can be considered to run clockwise from the vehicle's horizontal plane i.e., from the left side of the vehicle, forming a semi-circle axis in front of the vehicle. The sensors capture values every 10 degrees on this axis, clipped to a maximum value of 200m. These values depict the presence of a road boundary at the corresponding angle value. Mathematically, for $R^t$ as the vector of range finder sensors at any time instance t, define:

$$i = argmax(R_t)$$

$$\theta_t = 10i - \frac{\pi}{2}$$

$$l_t = R_t^i$$

Use the output from the heuristic function to provide target labels for the learning block. The loss function is based on RMSE (Root Mean Squared Error), minimizing the error between the heuristic output and predicted values from the learning block. This is optimized using a simple Mini-Batch Gradient Descent with Adam Optimizer until an arbitrary point of convergence where the mean loss function value across mini-batches falls below a threshold.

In the second phase the digital twin is trained as a whole, end to end on the path. Refer to the complete digital twin M as the connected neural network with the learning (L), learning (R) and learning (P) blocks, as shown in FIG. 5. The learned weights from Phase I are used to initialize the learning block. Then train M on the second dataset (D_2) comprising traffic scenarios, with the observed steering values as target values from which the digital twin can learn. The training is based on the explanation in the previous section.

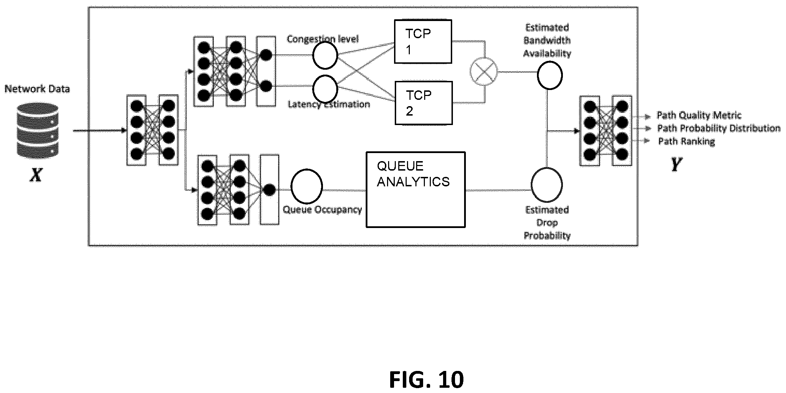

FIG. 10 is a schematic diagram of a digital twin for controlling a Border Gateway Control Protocol communications network. In the example of FIG. 10 the digital twin has four learning blocks and two physics blocks. Sensor data is obtained from the border gateway control protocol communications network and is denoted X "network data" in FIG. 10. The sensor data is input to a first learning block of the digital twin which computes predictions that are input in parallel to two child learning blocks, one concerned with congestion and latency in the communications network and another concerned with queue occupancy. The child learning block concerned with congestion and latency computes a predicted congestion level and also computes a predicted latency estimation. Those predictions are input to two transport control protocol TCP models (indicated as TCP 1 and TCP 2). The results from the TCP models are aggregated to produce an estimated bandwidth availability which is input to a final learning block that computes output Y.

The second child learning block, uses the outputs from the first learning block to compute a prediction of queue occupancy. The prediction is used by a physics block that encodes rules about queue behaviour. The output from the queue behaviour physics block is an estimate packet drop probability. The estimated packet drop probability is input to the final learning block together with the estimated bandwidth availability. The final learning block predicts a path quality metric, a path probability distribution and a path ranking.

In some examples, a digital twin with physics and learning blocks as described herein is used to compute inductive biases for network modelling, optimization, and control problems involving complex interconnected dynamics. The hybrid approach is able to overcome the limitations of purely analytical or empirical approaches.

In some examples the digital twin is a differentiable simulator for a network protocol like TCP, UDP, BGP etc. The digital twin embeds analytical models of how communications network protocols behave into black-box learning agents. This provides an inductive bias for these learning agents that interact with networks.

As illustrated in the example of FIG. 10, quality of service QoS factors like latency, throughput, and reliability are predicted by a digital twin by incorporating models of queueing, congestion control, and packet loss into black-box neural networks for digital twins. The layers of the neural network act as network emulators. For network control and optimization tasks, differentiable physics allows gradient-based end-to-end training of software-defined network controllers.

In an example, such as that of FIG. 10, a differentiable TCP model (TCP model 1 and TCP model 2 of FIG. 10) captures congestion control dynamics like slow start, congestion avoidance, and retransmit timeouts, allowing learning agents (the learning blocks of FIG. 10) to understand TCP flow control impacts.

For routing, a differentiable BGP model is able to simulate path selection and propagation based on policies and relationships. This provides insights into routing changes.

Queueing theory simulators such as the queueing analytics physics block of FIG. 10 model buffering delays and backbone congestion. The predictions from the digital twin of FIG. 10 are useful for optimizing software defined network SDN traffic engineering. Differentiable loss models are used to capture the impacts of imperfect links and noisy wireless channels on reliability.

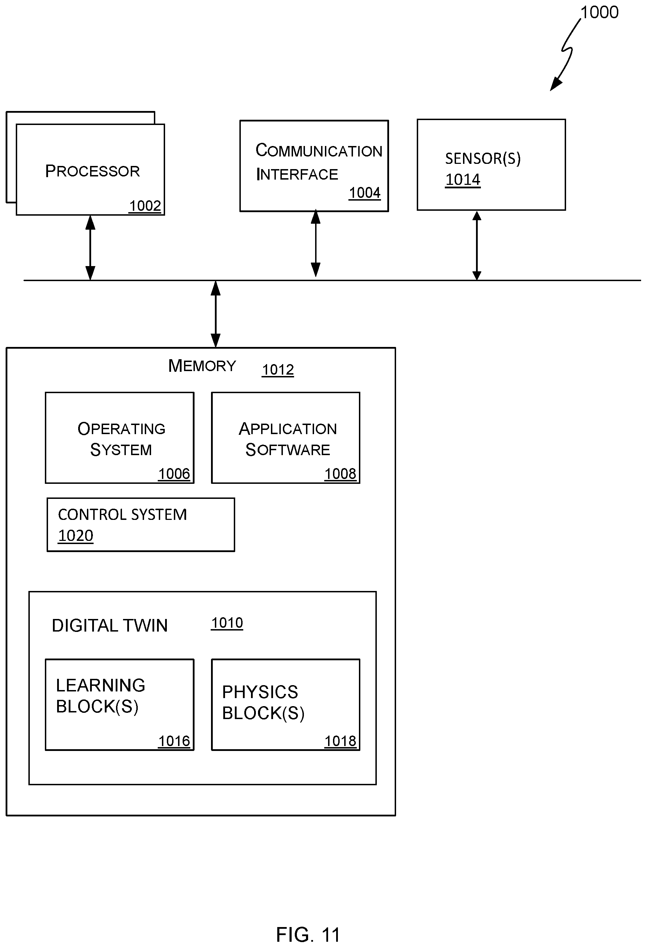

FIG. 11 illustrates various components of an example computing device 1000 in which a digital twin is implemented in some examples. The computing device is of any suitable form such as a desktop computer, an unmanned aerial vehicle, a laptop computer, a self-driving vehicle, a communications network node.

The computing device 1000 comprises one or more processors 1002 which are microprocessors, controllers or any other suitable type of processors for processing computer executable instructions to control the operation of the device in order to perform the methods of figures 3 to 8. In some examples, for example where a system on a chip architecture is used, the processors 1002 include one or more fixed function blocks (also referred to as accelerators) which implement a part of the method of figures 3 to 8 in hardware (rather than software or firmware). That is, the methods described herein are implemented in any one or more of software, firmware, hardware. The computing device has a data store holding training data, simulated values, sensor data, predictions and other data. The computing device has a digital twin 1010 comprising at least one learning block 1016 and at least one physics block 1018. Platform software comprising an operating system 1006 or any other suitable platform software is provided at the computing-based device to enable application software 1008 to be executed on the device. Although the computer storage media (memory 1012) is shown within the computing-based device 1000 it will be appreciated that the storage is, in some examples, distributed or located remotely and accessed via a network or other communication link (e.g. using communication interface 1004).

The computing-based device 1000 is arranged to output display information to a display device which may be separate from or integral to the computing-based device such as to display a graphical user interface with an explanation of a prediction. The computing-based device 1000 optionally has one or more sensors 1014 to sense data for input to the digital twin 1010.

Any reference to 'an' item refers to one or more of those items. The term 'comprising' is used herein to mean including the method blocks or elements identified, but that such blocks or elements do not comprise an exclusive list and an apparatus may contain additional blocks or elements and a method may contain additional operations or elements. Furthermore, the blocks, elements and operations are themselves not impliedly closed.

The steps of the methods described herein may be carried out in any suitable order, or simultaneously where appropriate. The arrows between boxes in the figures show one example sequence of method steps but are not intended to exclude other sequences or the performance of multiple steps in parallel. Additionally, individual blocks may be deleted from any of the methods without departing from the spirit and scope of the subject matter described herein. Aspects of any of the examples described above may be combined with aspects of any of the other examples described to form further examples without losing the effect sought. Where elements of the figures are shown connected by arrows, it will be appreciated that these arrows show just one example flow of communications (including data and control messages) between elements. The flow between elements may be in either direction or in both directions.

Where the description has explicitly disclosed in isolation some individual features, any apparent combination of two or more such features is considered also to be disclosed, to the extent that such features or combinations are apparent and capable of being carried out based on the present specification as a whole in the light of the common general knowledge of a person skilled in the art, irrespective of whether such features or combinations of features solve any problems disclosed herein. In view of the foregoing description it will be evident to a person skilled in the art that various modifications may be made within the scope of the invention.

## Claims

1. A computer implemented method comprising:

   receiving sensor data observed from an entity;
   inputting the sensor data to a digital twin of the entity, the digital twin comprising at least one learning block, and at least one physics block encoding a rule;
   processing the sensor data through the learning block and the physics block such that the data follows a path through the digital twin through the blocks and along one or more connections between the blocks to generate an output;
   triggering control of the entity in dependence on the generated output.

2. The method of claim 1 wherein the digital twin has been trained using supervised learning, by backpropagation along the whole of the path, and wherein the backpropagation comprises computing gradients of a loss that is constrained by the physics block.

3. The method of claim 1 or claim 2 comprising generating an explanation of the output, the explanation comprising values of the sensor data processed through the physics block, information about the rule encoded by the physics block, and optionally an output of the data block.

4. The method of any preceding claim wherein the path comprises at least one residual block trained to predict a residual.

5. The method of any preceding claim comprising connecting the learning block and the physics bock either in series or in parallel.

6. The method of any preceding claim wherein the entity is any of: a self-driving vehicle, a communications network, a software-defined network.

7. The method of any preceding claim wherein the entity is a communications network and the physics block encodes any of: a rule about behaviour of a queue in a Border Gateway Protocol node of the communications network, a rule about behaviour of a node in the communications network using transport control protocol, a rule about traffic engineering in a software defined network.

8. The method of any preceding claim wherein the entity is a communications network and the learning block predicts any of: latency of packet transmission, throughput of packets, packet loss, buffering delay, backbone congestion.

9. The method of any preceding claim comprising any of: adding a block to the path, removing a block from the path.

10. The method of any preceding claim comprising training the digital twin using supervised learning, by backpropagation along the whole of the path, and wherein the backpropagation comprises computing gradients of a loss that is constrained by the physics block.

11. The method of claim 10 comprising inputting the sensor data to a simulator to compute simulated values of the output and using the simulated values to compute the loss.

12. The method of any preceding claim wherein the entity is a self-driving vehicle and wherein the learning block predicts a lookahead distance and wherein the physics block comprises mathematical operators.

13. The method of any preceding claim wherein the entity is a border gateway control protocol communications network and wherein the digital twin comprises a plurality of learning blocks and a plurality of physics blocks.

14. A computer implemented method comprising:

receiving sensor data observed from an entity;
inputting the sensor data to a digital twin of the entity, the digital twin comprising at least one learning block, and at least one physics block encoding a rule;
processing the sensor data through the learning block and the physics block such that the data follows a path through the digital twin along one or more connections between the blocks and generates an output;
training the digital twin by computing a loss from the generated output and propagating the loss along the path, the loss being constrained by the physics block.

15. An apparatus comprising:

a memory storing sensor data observed from an entity;
a digital twin of the entity, the digital twin comprising at least one learning block, and at least one physics block encoding a rule;
a processor to process the sensor data through the learning block and the physics block such that the sensor data follows a path through the digital twin along one or more connections between the blocks and generates an output;
the processor triggering control of the entity in dependence on the generated output.

**FIG. 1**

SELF-DRIVING
VEHICLE 208

SENSOR DATA
102

DIGITAL TWIN 100

PHYSICS &
LEARNING
BLOCKS 104

CONTROL SYSTEM
106

**FIG. 2**

**FIG. 3**

RECEIVE SENSOR DATA    300

INPUT SENSOR DATA TO CONNECTED BLOCK(S) TRAINED END TO END 402

COMPUTE PREDICTION 404

TRIGGER CONTROL 408

OPTIONALLY OUTPUT EXPLANATION 406

**FIG. 4**

FIG. 5

**FIG. 6**

L = small

Path

Regaining the path
L = look ahead distance

L = large

## FIG. 7

path ahead

Selected
Point

$\theta$

$+y$

i=r

i=4

Sensor Range
= 200m

i=3

i=15

10° intervals

i=2

i=16

i=1

i=17

i=0

i=18

-x

+x

ego vehicle

## FIG. 8

**FIG. 9**

FIG. 10

1000

PROCESSOR

1002

COMMUNICATION
INTERFACE
1004

SENSOR(S)
1014

MEMORY    1012

OPERATING
SYSTEM
1006

APPLICATION
SOFTWARE
1008

CONTROL SYSTEM
1020

DIGITAL TWIN    1010

LEARNING
BLOCK(S)
1016

PHYSICS
BLOCK(S)
1018

FIG. 11

Europäisches
Patentamt

European
Patent Office

Office européen
des brevets

# EUROPEAN SEARCH REPORT

**Application Number**

EP 23 21 4445

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/278582 A1 (ZHANG CHRIS JIA HAN [CA] ET AL) 7 September 2023 (2023-09-07) * paragraphs [0004], [0018], [0028], [0043]; claim 8; figures 1,10A * | 1-15 | INV. G06N3/042 G06N3/045 G06N3/084 G06N5/045 |
| X | US 2019/382007 A1 (CASAS SERGIO [CA] ET AL) 19 December 2019 (2019-12-19) | 1,2,6, 10,13-15 | |
| A | * paragraphs [0007], [0038] - [0039], [0094]; claim 1; figures 1,8 * | 3-5,7-9, 11,12 | ADD. G05B17/00 B60W40/00 G05B17/02 |

**TECHNICAL FIELDS SEARCHED (IPC)**

G06N

The present search report has been drawn up for all claims

| Place of search | Date of completion of the search | Examiner |
|---|---|---|
| The Hague | 22 May 2024 | Manfrin, Max |

EPO FORM 1503 03.82 (P04C01)

## ANNEX TO THE EUROPEAN SEARCH REPORT
## ON EUROPEAN PATENT APPLICATION NO.

EP 23 21 4445

This annex lists the patent family members relating to the patent documents cited in the above-mentioned European search report.
The members are as contained in the European Patent Office EDP file on
The European Patent Office is in no way liable for these particulars which are merely given for the purpose of information.

22-05-2024

| Patent document cited in search report | Publication date | Patent family member(s) | Publication date |
|---|---|---|---|
| US 2023278582 A1 | 07-09-2023 | CA 3192118 A1 | 07-09-2023 |
| | | US 2023278582 A1 | 07-09-2023 |
| US 2019382007 A1 | 19-12-2019 | US 2019382007 A1 | 19-12-2019 |
| | | US 2022289180 A1 | 15-09-2022 |
| | | US 2023415788 A1 | 28-12-2023 |

EPO FORM P0459

For more details about this annex : see Official Journal of the European Patent Office, No. 12/82